# EUROPEAN PATENT APPLICATION

(11) **EP 4 760 462 A1**
(43) Date of publication of application: **17.06.2026**
(21) Application number: 25176304.1
(22) Date of filing: 14.05.2025
(51) Int. Cl.: G06F 3/01

(54) **TRANSPARENT, STRETCHABLE, SEAMLESS HAPTIC SPECTRUM ACTUATOR DEVICE**

(30) Priority: 12.12.2024 KR 20240184834
(71) Applicant: Korea University of Technology and Education Industry - University Cooperation Foundation, Chungcheongnam-do 31253 (KR)
(72) Inventor: HEO, Yong Hae, 31253 Cheonan-si, Chungcheongnam-do (KR); KIM, Sang Youn, 06276 Seoul (KR)
(74) Representative: Cabinet Chaillot

(57) **Abstract**

A transparent, stretchable, seamless haptic-spectrum actuator device according to the present invention includes a first electrode unit having a voltage polarity due to a power supply voltage applied from a power supply unit; a second electrode unit arranged apart from the first electrode unit and having a voltage polarity different from that of the first electrode unit due to the power supply voltage applied from the power supply unit; and an electroactive gel arranged to be in contact with the first electrode unit and the second electrode unit and electrically connecting the first electrode unit and the second electrode unit.

## Description

### CROSS-REFERENCE TO RELATED APPLICATIONS

This application claims priority to and the benefit of Korean Patent Application No. 10-2024-0184834 filed in the Korean Intellectual Property Office on December 12, 2024, the entire contents of which are incorporated herein by reference.

### TECHNICAL FIELD

The present invention relates to a transparent, stretchable, seamless haptic-spectrum actuator device, and more specifically, to a transparent, stretchable, seamless haptic-spectrum actuator device in which a first electrode unit and a second electrode unit arranged apart from each other are bonded to an electroactive gel, a voltage from a power supply unit is applied to the first electrode unit and the second electrode unit to generate a first electric field by first polarization charges induced on a gel surface of the electroactive gel, thereby applying an electrostatic attractive force to a body surface to provide a first haptic to a user in both a non-contact mode in which the electroactive gel and the body surface are not in contact and a contact mode in which the electroactive gel and the body surface are in contact, and the voltage from the power supply unit is applied to the first electrode unit and the second electrode unit to deform a shape of the electroactive gel by causing a plasticizer and a polymer chain of the electroactive gel to move to one of the first electrode unit and the second electrode unit, thereby vibrating the body surface to provide a second haptic to the user in a contact mode.

### BACKGROUND ART

Recently, most touch interface devices provide tactile feedback to offer users a variety of vivid sensations.

**In** the related art, tactile feedback mostly involves vibration stimulation using a vibration actuator. Recently, however, researches are actively being conducted on technologies that provide various textures to enhance user experience.

Texture rendering methods of the related art include various types, such as a method of providing different frictional sensations in response to finger movement by changing the frictional force of a touch surface using ultrasonic vibration, a method of providing frictional sensations by arranging piezoelectric element actuators in a matrix form to change the frictional force between a finger and a vibrating surface, a method of providing stimulation using suction force of air, a method of providing electrical stimulation, and a method of providing stimulations of cold and warm sensations using temperature differences.

However, the texture rendering methods of the related art have a disadvantage in that they are difficult to apply to portable devices due to their large and complex hardware configuration.

Accordingly, technologies for rendering tactile sensations and textures using electroactive polymers have recently been introduced.

Electroactive polymers are materials capable of reproducibly exhibiting expansion, contraction, and bending phenomena in response to electrical stimulation. Due to their fast response speed and wide operating frequency range, they have recently attracted attention in fields such as tactile actuators, artificial muscles, artificial hearts, smart skins, and ultra-precision machines.

### SUMMARY OF THE INVENTION

The present invention has been made in an effort to provide a transparent, stretchable, seamless haptic-spectrum actuator device, in which a first electrode unit and a second electrode unit arranged apart from each other are bonded to an electroactive gel, a voltage from a power supply unit is applied to the first electrode unit and the second electrode unit to generate a first electric field by first polarization charges induced on a gel surface of the electroactive gel, thereby applying an electrostatic attractive force to a body surface to provide a first haptic to a user in both a non-contact mode in which the electroactive gel and the body surface are not in contact and a contact mode in which the electroactive gel and the body surface are in contact, and a voltage from the power supply unit is applied to the first electrode unit and the second electrode unit to deform a shape of the electroactive gel by causing a plasticizer and a polymer chain of the electroactive gel to move to one of the first electrode unit and the second electrode unit, thereby vibrating the body surface to provide a second haptic to the user in a contact mode.

A transparent, stretchable, seamless haptic-spectrum actuator device according to the present invention includes a first electrode unit having a voltage polarity due to a power supply voltage applied from a power supply unit; a second electrode unit arranged apart from the first electrode unit and having a voltage polarity different from that of the first electrode unit due to the power supply voltage applied from the power supply unit; and an electroactive gel arranged to be in contact with the first electrode unit and the second electrode unit and electrically connecting the first electrode unit and the second electrode unit.

Preferably, the electroactive gel may induce first polarization charges on a gel surface by a first electric field generated by the power supply voltage applied to the first electrode unit and the second electrode unit, and the transparent, stretchable, seamless haptic-spectrum actuator device according to the present invention may apply an electrostatic attractive force to a body surface of a user spaced from or in contact with the gel surface by a second electric field generated from the induced first polarization charges.

Preferably, the electroactive gel may periodically change an induction direction of the first polarization charges induced on the gel surface when the power supply voltage is an alternating current (AC) voltage, and the transparent, stretchable, seamless haptic-spectrum actuator device according to the present invention may provide a first haptic, which is vibration of the body surface caused by the electrostatic attractive force that periodically changes with the periodic change in the induction direction of the first polarization charges.

Preferably, the electroactive gel may include a plasticizer and a polymer chain, and preferably, the electroactive gel may undergo a shape deformation into a first deformed state as the plasticizer and the polymer chain move toward the first electrode unit, or into a second deformed state as the plasticizer and the polymer chain move toward the second electrode unit, by a first electric field generated by the power supply voltage applied to the first electrode unit and the second electrode unit.

Preferably, the electroactive gel may undergo a periodic shape deformation into either the first deformed state or the second deformed state when the power supply voltage is an alternating current (AC) voltage, and the transparent, stretchable, seamless haptic-spectrum actuator device may provide a second haptic, which is vibration of a body surface of a user in contact with a gel surface of the electroactive gel, caused by the periodic shape deformation of the electroactive gel.

Preferably, the first electrode unit may include a first main electrode formed in a rod shape, and a plurality of first sub-electrodes, each formed in a rod shape and protruding from the first main electrode toward a second main electrode, forming a predetermined angle with the first main electrode, the second electrode unit may include a second main electrode formed in a rod shape, and spaced apart from and arranged parallel to the first main electrode, and a plurality of second sub-electrodes, each formed in a rod shape and protruding from the second main electrode toward the first main electrode, forming a predetermined angle with the second main electrode, and the plurality of first sub-electrodes and the plurality of second sub-electrodes may be arranged such that the second sub-electrodes are adjacent to the first sub-electrodes.

An aspect of the present invention has an advantage in that a first electrode unit and a second electrode unit arranged apart from each other are bonded to an electroactive gel, a voltage from a power supply unit is applied to the first electrode unit and the second electrode unit to generate a first electric field by first polarization charges induced in a gel surface of the electroactive gel, thereby applying an electrostatic attractive force to a body surface to provide a first haptic to a user in both a non-contact mode in which the electroactive gel and the body surface are not in contact and a contact mode in which the electroactive gel and the body surface are in contact, and the voltage from the power supply unit is applied to the first electrode unit and the second electrode unit to deform a shape of the electroactive gel by causing a plasticizer and a polymer chain of the electroactive gel to move to one of the first electrode unit and the second electrode unit, thereby vibrating the body surface to provide a second haptic to the user in a contact mode.

### BRIEF DESCRIPTION OF THE DRAWINGS

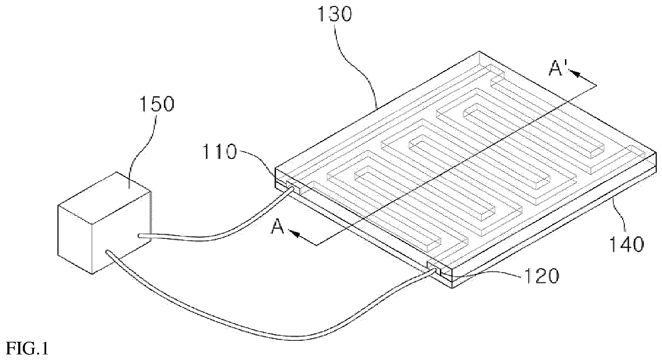

FIG. 1 is a perspective view of a transparent, stretchable, seamless haptic-spectrum actuator device according to an exemplary embodiment of the present invention.

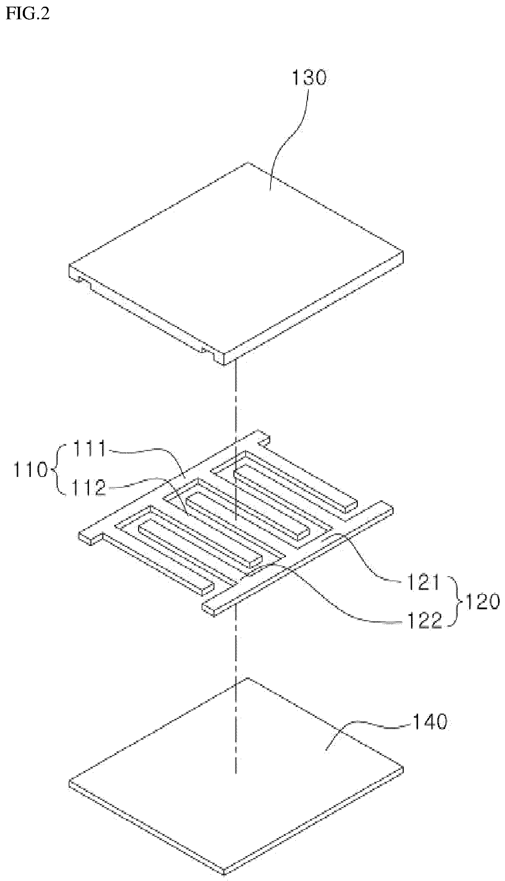

FIG. 2 is a top exploded perspective view of the transparent, stretchable, seamless haptic-spectrum actuator device according to an exemplary embodiment of the present invention.

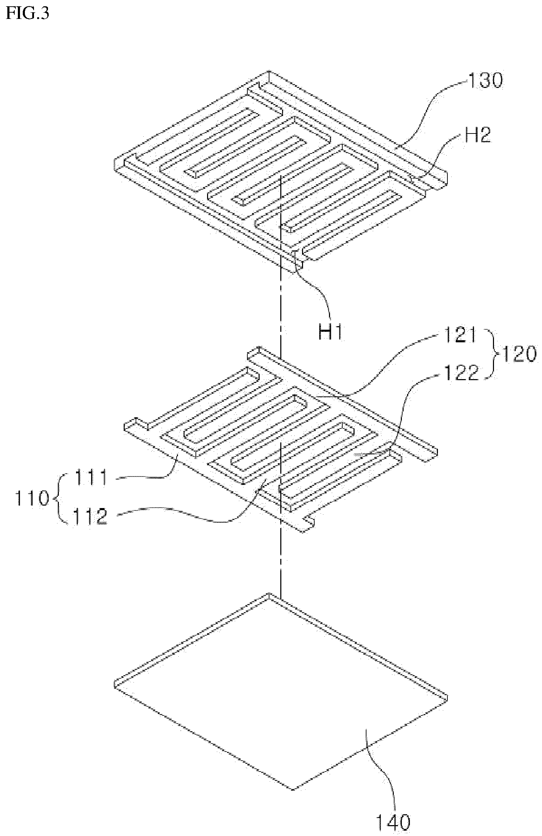

FIG. 3 is a bottom exploded perspective view of the transparent, stretchable, seamless haptic-spectrum actuator device according to an exemplary embodiment of the present invention.

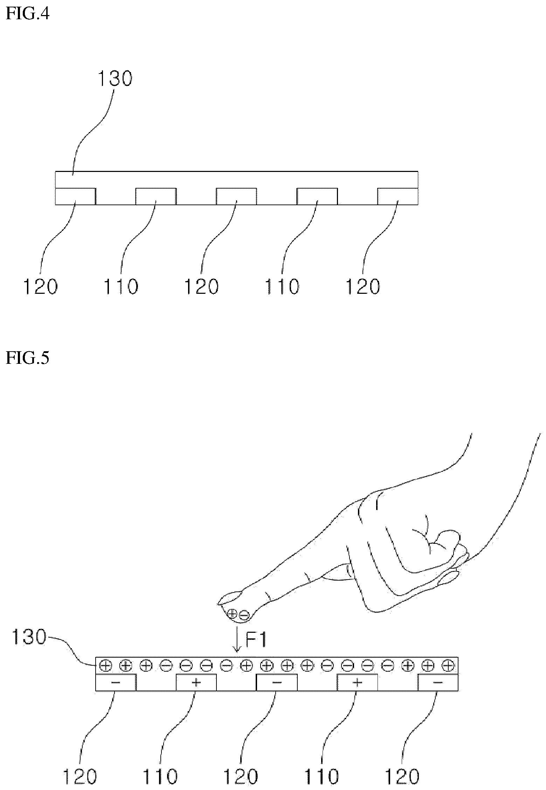

FIG. 4 is a cross-sectional view of the transparent, stretchable, seamless haptic-spectrum actuator device according to an embodiment of the present invention, taken along line A-A' of FIG. 1.
FIG. 5 is a cross-sectional view of the transparent, stretchable, seamless haptic-spectrum actuator device according to an embodiment of the present invention, taken along line A-A' of FIG. 1, and illustrates an example in which the transparent, stretchable, seamless haptic-spectrum actuator device according to an embodiment of the present invention applies an electrostatic attractive force to a body surface.

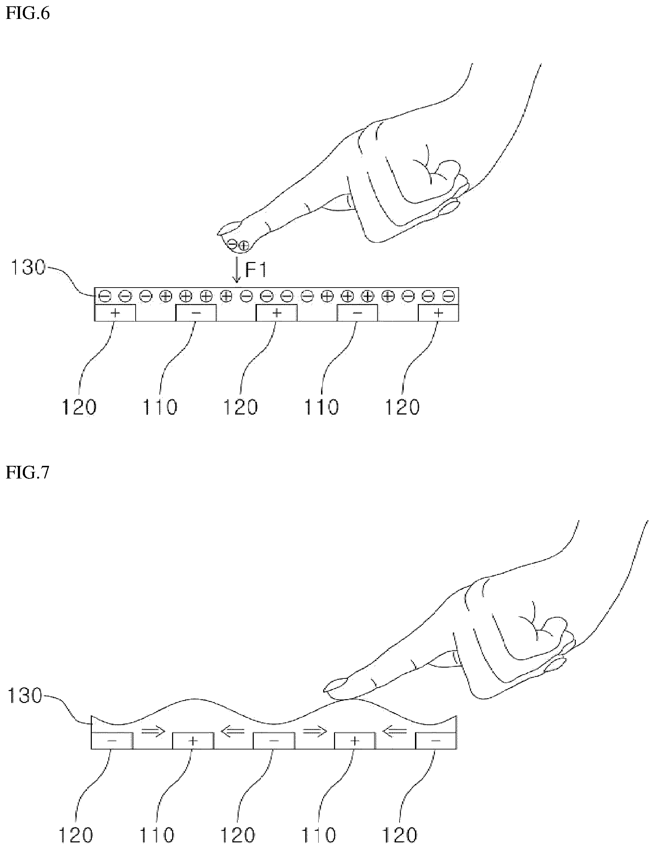

FIG. 6 is a cross-sectional view of the transparent, stretchable, seamless haptic-spectrum actuator device according to an embodiment of the present invention, taken along line A-A' of FIG. 1, and illustrates another example in which the transparent, stretchable, seamless haptic-spectrum actuator device according to an embodiment of the present invention applies an electrostatic attractive force to a body surface.
FIG. 7 is a cross-sectional view of the transparent, stretchable, seamless haptic-spectrum actuator device according to an embodiment of the present invention, taken along line A-A' of FIG. 1, and illustrates a state in which an electroactive gel of the transparent, stretchable, seamless haptic-spectrum actuator device according to an embodiment of the present invention is deformed into a first deformed state.

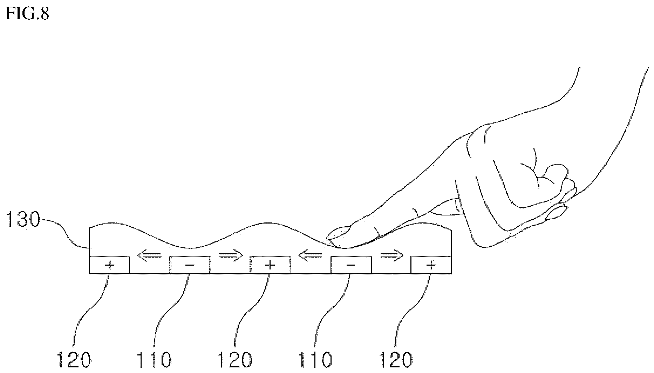

FIG. 8 is a cross-sectional view of the transparent, stretchable, seamless haptic-spectrum actuator device according to an embodiment of the present invention, taken along line A-A' of FIG. 1, and illustrates a state in which an electroactive gel of the transparent, stretchable, seamless haptic-spectrum actuator device according to an embodiment of the present invention is deformed into a second deformed state.

### DETAILED DESCRIPTION

Hereinafter, preferred exemplary embodiments will be presented for better understanding of the present invention. However, the following exemplary embodiments are only provided so that the present invention can be more easily understood. Therefore, the content of the present invention should not be construed as being limited to the exemplary embodiments set forth herein.

FIG. 1 is a perspective view of a transparent, stretchable, seamless haptic-spectrum actuator device according to an exemplary embodiment of the present invention, FIG. 2 is a top exploded perspective view of the transparent, stretchable, seamless haptic-spectrum actuator device according to an exemplary embodiment of the present invention, FIG. 3 is a bottom exploded perspective view of the transparent, stretchable, seamless haptic-spectrum actuator device according to an exemplary embodiment of the present invention, and FIG. 4 is a cross-sectional view of the transparent, stretchable, seamless haptic-spectrum actuator device according to an embodiment of the present invention, taken along line A-A' of FIG. 1.

Referring to FIGS. 1 to 4, a transparent, stretchable, seamless haptic-spectrum actuator device 100 (hereinafter, referred to as "actuator device") according to an exemplary embodiment of the present invention may include a first electrode unit 110, a second electrode unit 120, and an electroactive gel 130.
The first electrode unit 110 may have a voltage polarity due to a power supply voltage applied from a power supply unit 150.

The first electrode unit 110 may be formed of a transparent and stretchable material.

For example, the first electrode unit 110 may be formed of a hydrogel.

Additionally, the first electrode unit 110 may be formed to have a predetermined pattern.

Specifically, the first electrode unit 110 may include a first main electrode 111 and a plurality of first sub-electrodes 112.

The first main electrode 111 may be formed in a rod shape and spaced apart from and arranged parallel to a second main electrode 121 described below.

The plurality of first sub-electrodes 112 may each be formed in a rod shape and protrude from the first main electrode 111 toward the second main electrode 121, forming a predetermined angle with the first main electrode 111.

For example, the plurality of first sub-electrodes 112 may be perpendicular to the first main electrode 111.

Additionally, the plurality of first sub-electrodes 112 may be arranged apart from a plurality of second sub-electrodes 112 described below.

The second electrode unit 120 may have a voltage polarity due to the power supply voltage applied from the power supply unit 150.

In this case, the second electrode unit 120 may have a voltage polarity different from the voltage polarity of the first electrode unit 120.

The second electrode unit 120 may be formed of a transparent and stretchable material.

For example, the second electrode unit 120 may be formed of a hydrogel.

Additionally, the second electrode unit 120 may be formed to have a predetermined pattern.

Specifically, the second electrode unit 120 may include a second main electrode 121 and a plurality of second sub-electrodes 122.

The second main electrode 121 may be formed in a rod shape and spaced apart from and arranged parallel to the first main electrode 111.

The plurality of second sub-electrodes 122 may each be formed in a rod shape and protrude from the second main electrode 121 toward the first main electrode 111, forming a predetermined angle with the second main electrode 121.

For example, the plurality of second sub-electrodes 122 may be perpendicular to the second main electrode 121.

Additionally, the plurality of second sub-electrodes 122 may be arranged apart from the plurality of first sub-electrodes 122.

Note that one second sub-electrode 122 may be spaced apart from and arranged between two adjacent first sub-electrodes 112 among the plurality of first sub-electrodes 112.

In other words, one first sub-electrode 112 may be spaced apart from and arranged between two adjacent second sub-electrodes 122 among the plurality of second sub-electrodes 122.

The electroactive gel 130 may be arranged in contact with the first electrode unit 110 and the second electrode unit 120 and electrically connect the first electrode unit 110 and the second electrode unit 120.

To this end, the electroactive gel 130 may have a first electrode groove H1 recessed on a lower surface thereof, into which the first electrode unit 110 can be inserted.

The first electrode groove H1 may be recessed in a shape corresponding to the pattern shape of the first electrode unit 110.

Additionally, the electroactive gel 130 may have a second electrode groove H2 recessed on the lower surface thereof, into which the second electrode unit 120 can be inserted.

The second electrode groove H2 may be recessed in a shape corresponding to the pattern shape of the second electrode unit 120.

Accordingly, when the first electrode unit 110 is inserted into the first electrode groove H1 and the second electrode unit 120 is inserted into the second electrode groove H2, the electroactive gel 130 may surround an upper surface and side surfaces of the first electrode unit 110, that is, an upper surfaces and side surfaces of each of the first main electrode 111 and the plurality of first sub-electrodes 112, and an upper surface and side surfaces of the second electrode unit 120, that is, an upper surface and side surfaces of each of the second main electrode 121 and the plurality of second sub-electrodes 122.

Accordingly, since the electroactive gel 130 is formed of a conductive material, it can electrically connect the first electrode unit 110 and the second electrode unit 120.

Here, the electroactive gel 130 may be a gel-like material composed of polymer chains and a plasticizer that flows between the polymer chains.

For example, the electroactive gel 130 may be made of an electroactive polymer (EAP), and as an example of the electroactive polymer (EAP), the electroactive gel 130 may be a PVC gel.

The PVC gel is composed of PVC chains and a dibutyl adipate (DBA) plasticizer, and pure PVC is plasticized by dibutyl adipate (DBA), in which dibutyl adipate (DBA) increases a free volume of the PVC chains and reduces the intermolecular attractive force of the PVC chains.

Note that, in an exemplary embodiment of the present invention, the actuator device 100 may further include a support plate 140 supporting the first electrode unit 110, the second electrode unit 120, and the electroactive gel 130 from the bottom.

The support plate 140 may be formed in a plate shape, and may support the first electrode unit 110, the second electrode unit 120, and the electroactive gel 130 while an upper surface thereof is in contact with a lower surface of each of the first electrode unit 110, the second electrode unit 120, and the electroactive gel 130.

Such a support plate 140 may be formed of a transparent and stretchable material.

The support plate 140 may be formed of the same material as the electroactive gel 130 or may be formed of a non-conductive material.

Note that, in an exemplary embodiment of the present invention, the actuator device 100 may further include the power supply unit 150 electrically connected to each of the first electrode unit 110 and the second electrode unit 120 to apply a power supply voltage to the first electrode unit 110 and the second electrode unit 120, and a control unit (not shown) that controls the power supply unit 150.

The power supply unit 150 may be composed of a voltage source, a circuit that electrically connects each of the first electrode unit 110 and the second electrode unit 120 to the voltage source, and a switch that turns the circuit on or off.

The control unit may control a power supply voltage output of the power supply unit 150.

Specifically, the control unit may output a control signal to the power supply unit 150, which controls whether to output the power supply voltage, a voltage magnitude of the power supply voltage, a voltage direction of the power supply voltage, and an AC frequency of the power supply voltage, and the power supply unit 150 may or may not output the power supply voltage in response to the control signal.

FIG. 5 is a cross-sectional view of the transparent, stretchable, seamless haptic-spectrum actuator device according to an embodiment of the present invention, taken along line A-A' of FIG. 1, and illustrates an example in which the transparent, stretchable, seamless haptic-spectrum actuator device according to an embodiment of the present invention applies an electrostatic attractive force to a body surface.

Referring to FIG. 5, when a power supply voltage is applied to the first electrode unit 110 and the second electrode unit 120, a first electric field may be generated between the first electrode unit 110 and the second electrode unit 120.

Accordingly, first polarization charges may be induced by the first electric field inside the electroactive gel 130 and on the gel surface.

Specifically, when a power supply voltage is applied to the first electrode unit 110 and the second electrode unit 120, and thus the voltage polarity of the first electrode unit 110 becomes positive (+), that is, the first electrode unit 110 becomes a positive electrode, and the voltage polarity of the second electrode unit 120 becomes negative (-), that is, the second electrode unit 120 becomes a negative electrode, negative charges among first polarization charges may be accumulated in a first gel surface region of the gel surface, which is closer to the first electrode unit 110 than to the second electrode unit 120, and positive charges among first polarization charges may be accumulated in a second gel surface region of the gel surface, which is closer to the second electrode unit 120 than to the first electrode unit 110, due to the first electric field.

Here, a power supply voltage applied such that the first electrode unit 110 becomes the positive electrode and the second electrode unit 120 becomes the negative electrode is called a first power supply voltage. Additionally, a power supply voltage applied such that that the first electrode unit 110 becomes the negative electrode and the second electrode unit 120 becomes the positive electrode is called a second power supply voltage.

Thereafter, a second electric field may be generated outward from the gel surface by the first polarization charges induced in the gel surface, and second polarization charges may be induced by the second electric field on a body surface of a user that is either spaced apart from the gel surface or in contact with the gel surface.

In this case, the actuator device 100 may apply an electrostatic attractive force F1, which is due to the second electric field, to the body surface.

Specifically, in a first body surface region of the body surface, which is closer to the positive charges among the first polarization charges than to the negative charges among the first polarization charges, due to the second electric field, negative charges among the second polarization charges may be accumulated, and in a second body surface region of the body surface, which is closer to the negative charges among the first polarization charges than to the positive charges among the first polarization charges, positive charges among the second polarization charges may be accumulated.

Accordingly, the electrostatic attractive force F1, which is due to the interaction between the second electric field and the second polarization charges, may be applied to the body surface.

FIG. 6 is a cross-sectional view of the transparent, stretchable, seamless haptic-spectrum actuator device according to an embodiment of the present invention, taken along line A-A' of FIG. 1, and illustrates another example in which the transparent, stretchable, seamless haptic-spectrum actuator device according to an embodiment of the present invention applies an electrostatic attractive force to a body surface.

Referring to FIG. 6, when the power supply voltage, i.e., the second power supply voltage is applied to the first electrode unit 110 and the second electrode unit 120, a first electric field having an opposite direction to that when the first power supply voltage is applied to the first electrode unit 110 and the second electrode unit 120 may be generated.

In this case as well, the first polarization charges may be induced by the first electric field inside the electroactive gel 130 and on the gel surface.

Specifically, when a power supply voltage is applied to the first electrode unit 110 and the second electrode unit 120, and thus the voltage polarity of the first electrode unit 110 becomes negative (1), that is, the first electrode unit 110 becomes a negative electrode, and the voltage polarity of the second electrode unit 120 becomes positive (-), that is, the second electrode unit 120 becomes a positive electrode, positive charges among first polarization charges may be accumulated in a first gel surface region of the gel surface, which is closer to the first electrode unit 110 than to the second electrode unit 120, and negative charges among first polarization charges may be accumulated in a second gel surface region of the gel surface, which is closer to the second electrode unit 120 than to the first electrode unit 110, due to the first electric field.

Thereafter, a second electric field having an opposite direction to that when the first power supply voltage is applied may be generated outward from the gel surface by the first polarization charges induced in the gel surface, and second polarization charges may be induced by the second electric field on a body surface of a user that is either spaced apart from the gel surface or in contact with the gel surface.

In this case as well, the actuator device 100 may apply an electrostatic attractive force F1, which is due to the second electric field, to the body surface.

Specifically, in a first body surface region of the body surface, which is closer to the positive charges among the first polarization charges than to the negative charges among the first polarization charges, due to the second electric field, negative charges among the second polarization charges may be accumulated, and in a second body surface region of the body surface, which is closer to the negative charges among the first polarization charges than to the positive charges among the first polarization charges, positive charges among the second polarization charges may be accumulated.

Accordingly, the electrostatic attractive force F1, which is due to the interaction between the second electric field and the second polarization charges, may be applied to the body surface.

A sensation perceived by the user due to the electrostatic attractive force F1 is defined as a first haptic.

Note that, when the actuator device 100 is repeatedly subjected to application and non-application of the first power supply voltage or to application and non-application of the second power supply voltage from the power supply unit 150, application and non-application of the electrostatic attractive force F1 to the body surface are repeated to vibrate the body surface, thereby providing the user with the first haptic.

In contrast, even when the actuator device 100 is supplied with a power supply voltage, which is an AC voltage that changes between the first power supply voltage and the second power supply voltage, from the power supply unit 150, application and non-application of the electrostatic attractive force F1 to the body surface are repeated to vibrate the body surface, thereby providing the user with the first haptic.

With this, the actuator device 100 can provide the first haptic to the user even in both a non-contact mode in which the body surface is spaced apart from the gel surface of the electroactive gel 130 and a contact mode in which the body surface is in contact with the gel surface of the electroactive gel 130.

In this case, in the non-contact mode, the body surface and the gel surface of the electroactive gel 130 need to be spaced apart from each other within a preset distance so that the electrostatic attractive force can be applied to the body surface to provide the first haptic to the user.

That is, the non-contact mode may be a state in which the body surface and the gel surface of the electroactive gel 130 are spaced apart from each other, but are spaced apart from each other within a preset distance.

Note that, referring again to FIG. 4, if the power supply voltage is not applied to the first electrode unit 110 and the second electrode unit 120 arranged in contact with the electroactive gel 130, the plasticizer molecules present in the electroactive gel 130 may move irregularly, and the shape of the stretchable electroactive gel 130 may remain undeformed.

FIG. 7 is a cross-sectional view of the transparent, stretchable, seamless haptic-spectrum actuator device according to an embodiment of the present invention, taken along line A-A' of FIG. 1, and illustrates a state in which an electroactive gel of the transparent, stretchable, seamless haptic-spectrum actuator device according to an embodiment of the present invention is deformed into a first deformed state.

Referring to FIG. 7, when the power supply voltage is applied to the first electrode unit 110 and the second electrode unit 120 arranged in contact with the electroactive gel 130, the plasticizer molecules move, and due to the movement of the plasticizer molecules, the polymer chain molecules may also move.

Accordingly, the shape of the electroactive gel 130 may be deformed due to the movements of the plasticizer molecules and the polymer chain molecules.

Specifically, when the first power supply voltage is applied to the first electrode unit 110 and the second electrode unit 120, the plasticizer and polymer chains move toward the first electrode unit 110, which is a positive electrode, so that the electroactive gel 130 may be deformed into a first deformed state.

More specifically, when the electroactive gel 130 is deformed into the first deformed state, the electroactive gel 130 may expand in a first region close to the first electrode unit 110, which is a positive electrode, and contract in a second region close to the second electrode unit 110, which is a negative electrode.

In other words, when the electroactive gel 130 is deformed into the first deformed state, the first region of the electroactive gel 130 close to the first electrode unit 110, which is a positive electrode, may become thicker, and the second region close to the second electrode unit 110, which is a negative electrode, may become thinner.

FIG. 8 is a cross-sectional view of the transparent, stretchable, seamless haptic-spectrum actuator device according to an embodiment of the present invention, taken along line A-A' of FIG. 1, and illustrates a state in which an electroactive gel of the transparent, stretchable, seamless haptic-spectrum actuator device according to an embodiment of the present invention is deformed into a first deformed state.

Referring to FIG. 8, when the power supply voltage is applied to the first electrode unit 110 and the second electrode unit 120 arranged in contact with the electroactive gel 130, the plasticizer molecules move, and due to the movement of the plasticizer molecules, the polymer chain molecules may also move.

When the second power supply voltage is applied to the first electrode unit 110 and the second electrode unit 120, the plasticizer and polymer chains move toward the second electrode unit 120, which is a positive electrode, so that the electroactive gel 130 may be deformed into a second deformed state.

More specifically, when the electroactive gel 130 is deformed into the second deformed state, the electroactive gel 130 may expand in a second region close to the second electrode unit 120, which is a positive electrode, and contract in a first region close to the first electrode unit 110, which is a negative electrode.

In other words, when the electroactive gel 130 is deformed into the second deformed state, the second region of the electroactive gel 130 close to the second electrode unit 120, which is a positive electrode, may become thicker, and the first region close to the first electrode unit 110, which is a negative electrode, may become thinner.

Note that, when the application and non-application of the first power supply voltage or the application and non-application of the second power supply voltage from the power supply unit 150 are repeated, vibrations due to the repeated deformation of the electroactive gel 130 may occur on the body surface, thereby providing the user with a second haptic.

For example, when the application and non-application of the first power supply voltage from the power supply unit 150 are repeated and the body surface comes into contact with the first region of the electrode active gel 130 close to the first electrode unit 110, the protrusion of the first region toward the body surface is repeated to vibrate the body surface, thereby providing the second haptic to the user.

As another example, when the application and non-application of the second power supply voltage from the power supply unit 150 are repeated and the body surface comes into contact with the second region of the electrode active gel 130 close to the second electrode unit 120, the protrusion of the second region toward the body surface is repeated to vibrate the body surface, thereby providing the second haptic to the user.

Note that, when a power supply voltage, which is an AC voltage that changes between the first power supply voltage and the second power supply voltage, is applied from the power supply unit 150, and the body surface comes into contact with the gel surface of the electrode-active gel 130, repeated deformation of the electrode-active gel 130 vibrates the body surface, thereby providing the second haptic to the user.

With this, the actuator device 100 can provide the user with the second haptic as well as the first haptic in the contact mode in which the body surface is in contact with the gel surface of the electroactive gel 130.

With this, the user may receive the first haptic in the non-contact mode and additionally receive the second haptic when the mode is changed to the contact mode, and when the user receives both the first haptic and the second haptic in the contact mode and the mode is changed to the non-contact mode, the user may continue to receive the first haptic, so that a sense of incongruity between the non-contact mode and the contact mode may not be perceived.

Note that the actuator device 100 according to an exemplary embodiment of the present invention may further include the control unit (not shown).

When the power supply voltage is an AC voltage, the control unit may check, from reference data in which a minimum frequency is mapped to each of a plurality of reference voltage magnitude ranges, a reference voltage magnitude range including a voltage magnitude of a current power supply voltage.

Thereafter, the control unit may check a minimum frequency mapped to the checked reference voltage magnitude range, and control the power supply unit 150 to change the power supply voltage so that a power supply frequency, which represents a frequency of the power supply voltage, exceeds the checked minimum frequency.

Here, when the power supply frequency of the current power supply voltage exceeds the minimum frequency mapped to the reference voltage magnitude range including the voltage magnitude of the current power supply voltage, the user can perceive the first haptic (vibration of the body surface due to the electrostatic attractive force) in the non-contact mode.

Accordingly, reference data may be constructed by measuring, through experiments, a minimum frequency, which is a minimum power supply frequency at which a user can perceive the first haptic in non-contact mode, for each reference voltage magnitude range.

Although the present invention has been described with reference to the preferred exemplary embodiments, it will be understood by one skilled in the art that various modifications and variations to the present invention can be made without departing from the technical spirit and scope of the present invention defined in the following claims.

### [Explanation of Reference Numerals and Symbols]

100: transparent, stretchable, seamless haptic-spectrum actuator device
110: first electrode unit
120: second electrode unit
130: electroactive gel
140: support plate
150: power supply unit

## Claims

1. A transparent, stretchable, seamless haptic-spectrum actuator device comprising:
a first electrode unit having a voltage polarity due to a power supply voltage applied from a power supply unit;
a second electrode unit arranged apart from the first electrode unit and having a voltage polarity different from that of the first electrode unit due to the power supply voltage applied from the power supply unit; and
an electroactive gel arranged to be in contact with the first electrode unit and the second electrode unit and electrically connecting the first electrode unit and the second electrode unit.

2. The transparent, stretchable, seamless haptic-spectrum actuator device of claim 1, wherein
the electroactive gel induces first polarization charges on a gel surface by a first electric field generated by the power supply voltage applied to the first electrode unit and the second electrode unit, and
the transparent, stretchable, seamless haptic-spectrum actuator device applies an electrostatic attractive force to a body surface of a user spaced from or in contact with the gel surface by a second electric field generated from the induced first polarization charges.

3. The transparent, stretchable, seamless haptic-spectrum actuator device of claim 2, wherein
the electroactive gel periodically changes an induction direction of the first polarization charges induced in the gel surface when the power supply voltage is an alternating current (AC) voltage, and
the transparent, stretchable, seamless haptic-spectrum actuator device provides a first haptic, which is vibration of the body surface caused by the electrostatic attractive force that periodically changes with the periodic change in the induction direction of the first polarization charges.

4. The transparent, stretchable, seamless haptic-spectrum actuator device of claim 1, wherein
the electroactive gel comprises a plasticizer and a polymer chain, and
the electroactive gel undergoes a shape deformation into a first deformed state as the plasticizer and the polymer chain move toward the first electrode unit, or into a second deformed state as the plasticizer and the polymer chain move toward the second electrode unit, by a first electric field generated by the power supply voltage applied to the first electrode unit and the second electrode unit.

5. The transparent, stretchable, seamless haptic-spectrum actuator device of claim 4, wherein
the electroactive gel undergoes a periodic shape deformation into either the first deformed state or the second deformed state when the power supply voltage is an alternating current (AC) voltage, and
the transparent, stretchable, seamless haptic-spectrum actuator device provides a second haptic, which is vibration of a body surface of a user in contact with a gel surface of the electroactive gel, caused by the periodic shape deformation of the electroactive gel.

6. The transparent, stretchable, seamless haptic-spectrum actuator device of claim 1, wherein
the first electrode unit comprises
a first main electrode formed in a rod shape, and
a plurality of first sub-electrodes, each formed in a rod shape and protruding from the first main electrode toward a second main electrode, forming a predetermined angle with the first main electrode,
the second electrode unit comprises
a second main electrode formed in a rod shape, and spaced apart from and arranged parallel to the first main electrode, and
a plurality of second sub-electrodes, each formed in a rod shape and protruding from the second main electrode toward the first main electrode, forming a predetermined angle with the second main electrode, and
the plurality of first sub-electrodes and the plurality of second sub-electrodes are arranged such that the second sub-electrodes are adjacent to the first sub-electrodes.
